# EUROPEAN PATENT APPLICATION

(11) **EP 4 571 810 A2**
(43) Date of publication of application: **18.06.2025**
(21) Application number: 24211406.4
(22) Date of filing: 07.11.2024
(51) Int. Cl.: H01J 37/147, H01J 37/244, H01J 37/26

(54) **METHOD AND SYSTEM FOR IMAGING A SAMPLE**

(30) Priority: 21.11.2023 US 202318516040
(71) Applicant: FEI COMPANY, Hillsboro, OR 97124 (US)
(72) Inventor: MALINSKY, Milos, Hillsboro, 97124 (US); SHANEL, Ondrej Ludmil, Hillsboro, 97124 (US); STEJSKAL, Pavel, Hillsboro, 97124 (US)
(74) Representative: Boult Wade Tennant LLP

(57) **Abstract**

A sample is imaged by directing charged particle beam towards a sample and form an irradiation zone. The charged particle beam is scanned so that the irradiation zone is scanned in the sample plane in a first direction and the radiations from a detection zone are detected by a detector. A first number of detecting pixels arranged along a first detector axis corresponding to the first detection axis is fewer than a second number of detecting pixels arranged along a second detector axis corresponding to the second detection axis.

## Description

### FIELD OF THE INVENTION

The present description relates generally to methods and systems for imaging a sample using a charged particle microscope, and more particularly, to scanning sample and collecting data in charged particle microscopy.

### SUMMARY

In one embodiment, a method for imaging a sample comprises directing a charged particle beam toward the sample and forming an irradiation zone in a sample plane; scanning the irradiation zone substantially in a first direction in the sample plane, and detecting radiations from a detection zone with multiple detecting pixels of a detector, wherein a first detector axis of the detector corresponds to a first detection axis of the detection zone, and a second detector axis of the detector corresponds to a second detection axis of the detection zone, wherein a first number of the multiple detecting pixels arranged along the first detector axis is lower than a second number of the multiple detecting pixels arranged along the second detector axis, and wherein the first detection axis is orientated at an angle of less than 45 degrees from the first direction; and reconstructing a sample image based on the radiations detected during the scan.

In another embodiment, a method for imaging a sample comprises directing a charged particle beam to the sample to form an irradiation zone in the sample plane, and detecting first radiations from a detection zone of the sample with multiple detecting pixels of a detector arranged along a first detector axis and a second detector axis, wherein a first number of the multiple detecting pixels arranged along the first detector axis is lower than a second number of the multiple detecting pixels arranged along the second detector axis; moving the irradiation zone and the detection zone in a first direction in the sample plane, and detecting second radiations from the detection zone with the multiple detecting pixels, wherein a first detection axis of the detection zone corresponds to the first detector axis, and a second detection axis of the detection zone corresponds to the second detector axis, and wherein an angle between the first direction and the first detection axis is less than 45 degrees; and reconstructing a sample image based on the first radiations and the second radiations.

In yet another embodiment, a charged particle microscope comprises a sample holder for positioning a sample in a sample plane; a charged particle column for directing a charged particle beam toward the sample plane and forming an irradiation zone in the sample plane; a pixelated detector for detecting radiations generated from a detection zone of the sample responsive to irradiating the sample with the charged particle beam, wherein a first detector axis of the detector corresponds to a first detection axis of the detection zone, and a second detector axis of the detector corresponds to a second detection axis of the detection zone; and a controller including a non-transitory memory for storing computer readable instructions and a processor, by executing the computer readable instructions in the processor, the charged particle microscope is configured to: scan, via the charged particle column, the irradiation zone substantially in a first direction in the sample plane; detect, via multiple pixels of the detector, radiations from the detection zone, wherein a first number of the multiple detecting pixels arranged along the first detector axis is lower than a second number of the multiple detecting pixels arranged along the second detector axis, and wherein an angle of the first direction from the first detection axis is less than 45 degrees; and reconstruct a sample image based on the radiations detected during the scan.

It should be understood that the summary above is provided to introduce in simplified form a selection of concepts that are further described in the detailed description. It is not meant to identify key or essential features of the claimed subject matter, the scope of which is defined uniquely by the claims that follow the detailed description. Furthermore, the claimed subject matter is not limited to implementations that solve any disadvantages noted above or in any part of this disclosure.

### BRIEF DESCRIPTION OF THE DRAWINGS

FIG. 1 illustrates an example of a charged particle microscope.
FIG. 2 illustrates one example of collecting data from a round sample region.
FIGS. 3A-3B show example irradiation zones and corresponding detection zones.
FIG. 3C shows one example arrangement of detecting pixels of a detector.
FIG. 3D show another example irradiation zones and corresponding detection zones.
FIGS. 4A-4H illustrates an example data collection scheme.
FIG. 5 illustrates another example of collecting data from a round sample region.
FIG. 6 shows a portion of FIG. 5.
FIG. 7 shows an example method for imaging a sample.

Like reference numerals refer to corresponding parts throughout the several views of the drawings.

### DETAILED DESCRIPTION

The following description relates to systems and methods for imaging a sample using a charged particle microscope. Charged particle microscope can be used for analyzing sample features and structures with high resolution. For radiation sensitive sample, high quality sample imaging with low-dose radiation can be challenging. However, highly sensitive and low noise-level detectors can be costly.

As an example, transmission electron microscopy (TEM) is a type of charged particle microscope that can provide high-resolution details of biological structures. One application of the TEM is for single particle analysis (SPA), wherein the structure of particles such as proteins or viruses may be reconstructed. Because the sample for SPA is usually highly radiation sensitive, lower-dose radiation during the imaging session is required. Direct electron detector (DED) is a leading technology for low-dose imaging. However, DED with a large field of view, which requires a detector with large array (i.e., with large number of detecting pixels), can be out of reach for potential users due to its high cost.

Further, the process for sample preparation may be very complex and time consuming. For example, in SPA, the sample (e.g., in the form of particles) is vitrified and imaged in the hole of a TEM grid. Oftentimes, the number of holes with good sample quality and particle distribution is limited. Therefore, it is crucial for acquiring as much high-quality data as possible given the limited amount of good quality samples. Therefore, there is a need for high efficiency, high effective and high throughput data collection scheme using relatively low-cost detector.

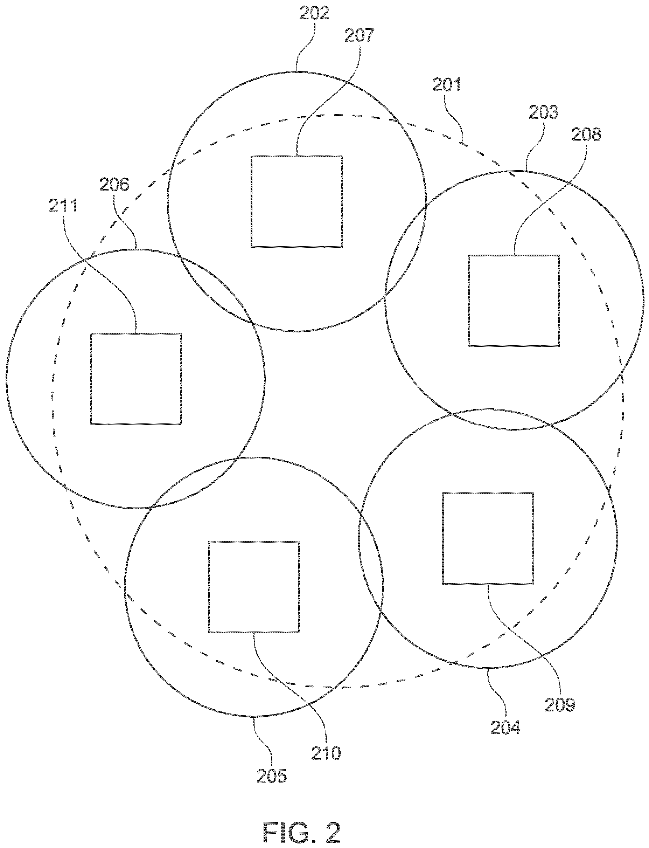

FIG. 2 shows an example scheme of acquiring SPA cryo-EM data from a single 2 um diameter hole 201 of a TEM grid. The hole is imaged using a circular beam (which forms a circular irradiation zone) at five beam locations shown as irradiation areas 202-206. A detector with a square detecting array is used for data collection. Within each of the circular irradiation areas 202-206, radiations originated from the respective square detection zone (207-211) are detected by the detector. The irradiation areas are arranged so that the detection zones are in the sample region irradiated only once, in order to avoid collecting data from radiation damaged sample (i.e., overlapped region of the irradiation areas). As a result, a relatively large areas of the hole 201 is not covered by any of the detection zones, and data from sample (e.g., particles) located in these areas are not collected. In other words, in this example, the data collection efficiency and effectiveness are low.

In order to address the above issues, a charged particle beam is directed towards a sample positioned in a sample plane, so that an irradiation zone is formed in the sample plane. The irradiation zone is a region irradiated by the charged particle beam and extends along a first irradiation axis and a second irradiation axis in the sample plane. The irradiation zone may be of any shape, such as rectangular, square, circular or oval. The irradiation zone is scanned/moved continuously or discretely substantially in a first direction in the sample plane.

Responsive to the irradiation, a detector receives radiations (such as charged particles, X-ray, or electromagnetic radiations) from a detection zone in the sample plane. The detection zone extends along a first detection axis and a second detection axis. The detection zone may locate within the irradiation zone. The size, shape, and the relative position of the detection zone with respect to the irradiation zone are determined and can be adjusted by the configuration of the system. The radiations from the detection zone are detected/received by multiple detecting pixels of the detector. The multiple detecting pixels are arranged along a first detector axis and a second detector axis of the detector to detect spatially resolved radiations. The first detector axis corresponds to or is aligned with the first detection axis, and the second detector axis corresponds to or is aligned with the second detection axis. In other words, radiations along the first detection axis are resolved along the first detector axis, and radiations along the second detection axis are resolved along the second detector axis. The first detection axis is oriented at an angle of less than 45 degrees from the first direction. When the first detection axis is at a nonzero degree from the first direction, the detection zone is tilted from (or not aligned) with the first direction.

The first number of the multiple detecting pixels arranged along the first detector axis is lower than a second number of the multiple detecting pixels arranged along the second detector axis. In one example, the detecting pixels arranged along the first detector axis can be one. That is, the multiple detecting pixels are arranged in an 1D array. In other examples, a width of the detection zone along the first detection axis is shorter than a length of the detection zone along the second detection axis. In yet another example, a width of an detector array formed by the multiple detecting pixels along the first detector axis is shorter than a length of the detector array along the second detector axis. As such, the number of the detecting pixels used for detecting the radiations (or active detecting pixels) may be reduced. In some examples, all detecting pixels of the detector are used for detecting the radiations. In some examples, a subset of the detecting pixels of the detector is used for detecting the radiations. In other examples, multiple different subsets of the detecting pixels of the detector are used during a single scan.

In some examples, the irradiation zone may be continuously scanned or moved in the sample plane substantially along a first irradiation axis in the first direction, and the radiations from the sample are acquired by the detector. In other examples, the sample is scanned at multiple beam locations substantially in the first direction using the charged particle beam. At each beam location, the irradiation zone is irradiated with the charged particle beam, and radiations from the detection zone within the irradiation zone are detected by a detector. By scanning "substantially" along the first irradiation axis (or in the first direction), the actual scan path may slightly deviate from the first irradiation axis (or in the first direction) but substantially follow the first irradiation axis (or in the first direction). For example, the actual beam position at a certain time point during the scan may be slightly shifted from the first direction, but the linear interpolation of the actual beam positions is within 10 degrees from the first irradiation axis.

In one example, the charged particle beam is directed to the sample to form the irradiation zone in the sample plane, and first radiations from the detection zone of the sample are detected with multiple detecting pixels of the detector arranged along the first detector axis and the second detector axis. The first number of the multiple detecting pixels arranged along the first detector axis is lower than the second number of the multiple detecting pixels arranged along the second detector axis. The irradiation zone and the detection zone are moved in a first direction in the sample plane, and second radiations from the detection zone are detected with the multiple detecting pixels. The first detection axis of the detection zone corresponds to the first detector axis, and the second detection axis of the detection zone corresponds to the second detector axis, and an angle between the first direction and the first detection axis is less than 45 degrees. The sample image is reconstructed based on the first radiations and the second radiations. In some examples, after detecting the second radiations, the irradiation zone and the detection zone are moved in a second direction and the third radiations from the detection zone are detected. The second direction may be determined based on the sample/system drift. In some examples, charged particle beam may be adjusted based on the sample/system drift while moving the irradiation zone. The second direction may be less than 45 degrees from the first direction. The sample image is further reconstructed based on the third detected radiations.

The angle between the first detection axis and the first direction may be less than 45 degrees, less than 30 degrees, or less than 10 degrees. In some examples, the first detection axis is substantially aligned or parallel to the first direction.

The charged particle beam or the irradiation zone may be scanned/moved substantially along the first irradiation axis by adjusting the one or more beam deflection coils that direct the charged particle beam towards the sample, and/or a beam limiting aperture in the beam path of the charged particle beam. While scanning of the irradiation zone (or the charged particle beam) in the first direction, the relative position of the detection zone with respect to the irradiation zone is not changed. That is, the detection zone is scanned in the sample plane at the same speed as the irradiation zone.

In some examples, the scan path of the irradiation zone may slightly deviate from the first direction, for example due to factors including the illumination of the electron beam, the orientation of the detector, and the sample/hole structure. The sample image may be reconstructed based on the scan direction of the irradiation zone and the scan speed. In some examples, the drift or the deviation from the scan path may be monitored during the scan, and the position of the irradiation zone in the sample plane, and/or the first direction (e.g., the scan direction), and/or the optical components for generating the charged particle beam may be adjusted based on the drift. The drift may be detected, for example, based on reconstructed images of part of the sample.

The sample image may be reconstructed based on the time information of the received radiation. For example, the radiations received may be spatially resolved along the first irradiation axis based on the time that the radiations are detected by the detector. In some examples, the particles of the radiations are temporally sampled with event-based detection. The sample image may be reconstructed further based on information about the movement of the charged particle beam. For example, the sample image may be reconstructed based on the direction and the scan speed of the irradiation zone. The sample image may further be reconstructed based on information of the detected radiations. For example, the sample image may further be reconstructed based on the speed of the detected electrons. In some examples, the sample image is reconstructed based on the scan speed, the scan direction, and the time of detected events.

In some embodiments, one or more inactive pixels may be positioned among the multiple detecting pixels for detecting radiations from the detection zone. The inactive pixels may be defected pixels in the 2D detector array. In some examples, one or more empty spaces may be positioned among the multiple detecting pixels. Because the irradiation zone is scanned over the sample and the image is reconstructed based on the time information of the received radiations from different part of the pixelated array, the method disclosed herein is less sensitive to the defected pixels in the detector array.

In this way, the number of detecting pixels for detecting the radiations can be reduced without sacrificing the detector's quality performance. Comparing to DED with a large field of view, herein, a detector with a lower number of detecting pixels can be used, and the same high-quality images of radiation sensitive sample can be acquired with a cheaper detector with lower number of detecting pixels. In some examples, the number of detecting pixels along the second detector axis may be 100-200 times of the number of the detecting pixels along the first detector axis. For example, the number of detecting pixels may be 2 along the first detector axis and 128 to 1024 along the second detector axis. Further, the spatial resolution of the detector along the first detector axis can be much lower than the second detector axis. By lowering the requirement of the detector, the cost of the detector may be further reduced.

In some examples, the first detector axis and the second detector axis are normal to each other. The first detection axis and the second detection axis are normal to each other. The irradiation zone may be formed by a beam limiting aperture positioned in the beam path of the charged particle beam. One example of forming the irradiation zone is discloses in U.S. patent US 11430633B2.

The multiple detecting pixels of the detector may be a subset of detecting pixels of the detector. For example, a rectangular array of detecting pixels in a circular, rectangular, or squared pixelated detector may be active for detecting the radiations.

The detection zone is a portion or the entirety of the irradiation zone, wherein the radiations from the detection zone are acquired by the detector and used to form the sample image. In some examples, the detection zone is smaller and within the irradiation zone. By having a bigger irradiation zone than the detection zone, the irradiation zone may extend to overlap with conductive materials surrounding the sample region and avoid charge buildup in the sample region.

The detection zone may be bounded by a first detection edge and a second detection edge parallel to the second detection axis, as well as a third detection edge and a fourth detection edge parallel to the first detection axis. The irradiation zone may be bounded by a first irradiation edge and a second irradiation edge, as well as a third irradiation edge and a fourth irradiation edge oriented along to the first direction. The first detection edge and the first irradiation edge are arranged toward the first direction relative to the second detection edge and the second irradiation edge.

In some examples, one or more of the detection edges and the irradiation edges may be straight. In some examples, one or more of the detection edges and the irradiation edges may be curved. The location of the detection zone relative to the irradiation zone may be adjusted by adjusting one or more image deflection coils positioned between the sample and/or adjusting the position and orientation of the detector. In some embodiments, one or both of the irradiation zone and the detection zone are rectangular.

During at least a portion of the scan and data collection process, a part of the irradiation zone may overlap with conductive materials surrounding the sample region. In this way, charges may be removed from the sample during the scan. In one example, the sample is vitrified in a sample region surrounded by supporting materials (such as carbon). The supporting materials surrounding the sample region may be electrically conductive. The sample region may be of any shape. For example, the sample region may be rectangular, square, or round. In one example, the sample region may be a hole of a TEM grid.

The detection zone may offset with respect to the irradiation zone. In other words, at least one of the central axes of the detection zone is not aligned with the central axis of the irradiation zone. The detection zone may offset with respect to the irradiation zone towards the scan direction (e.g., first direction). In some examples, at least one of the central axes of the detection zone parallel and normal to the first direction is not aligned with the respective central axis of the irradiation zone parallel and normal to the first direction. In one example, the detection zone offsets towards the scan direction relative to the irradiation zone. By offsetting the detection zone towards the scan direction, the irradiation zone may extend and overlap with materials opposite to the scan direction, therefore reducing potential radiation damage to the un-scanned sample region. In one example, a first distance between the first detection edge and the first irradiation edge is smaller than a second distance between the second detection edge and the second irradiation edge. The first distance may be non-zero, and determined based on a speed of the scan along the first axis and an estimated flux of the received radiation. By keeping the first distance non-zero, the initial radiations generated from a particular irradiation zone during the scan are not collected. This is because these initial radiations introduce beam induced particle movement and may reduce quality of received signals . One of the third and the fourth detection edges may substantially overlap with one of the third and fourth irradiation edges.

In one example, after scanning along the first direction, data from a first column of the sample region is collected. The irradiation zone is then shifted to collect data from a second column of the sample region. The first and second columns in the sample region are parallel, and may or may not overlap. The collected data may be selected during the post-processing for image reconstruction. To collect data from the second column, the irradiation zone may be shifted in a second direction by shifting the charged particle beam via adjusting the beam deflection coils and/or the moving/shifting the sample by adjusting the sample stage. The irradiation zone may also be shifted by moving the aperture positioned in the charged particle beam path and upstream of the sample plane. While scanning the irradiation zone, post beam correction is applied to adjust the relative position between the irradiation zone and the detection zone.

In this way, data from the majority of the sample region can be collected, thus achieving a high efficiency, high effective and high throughput data collection.

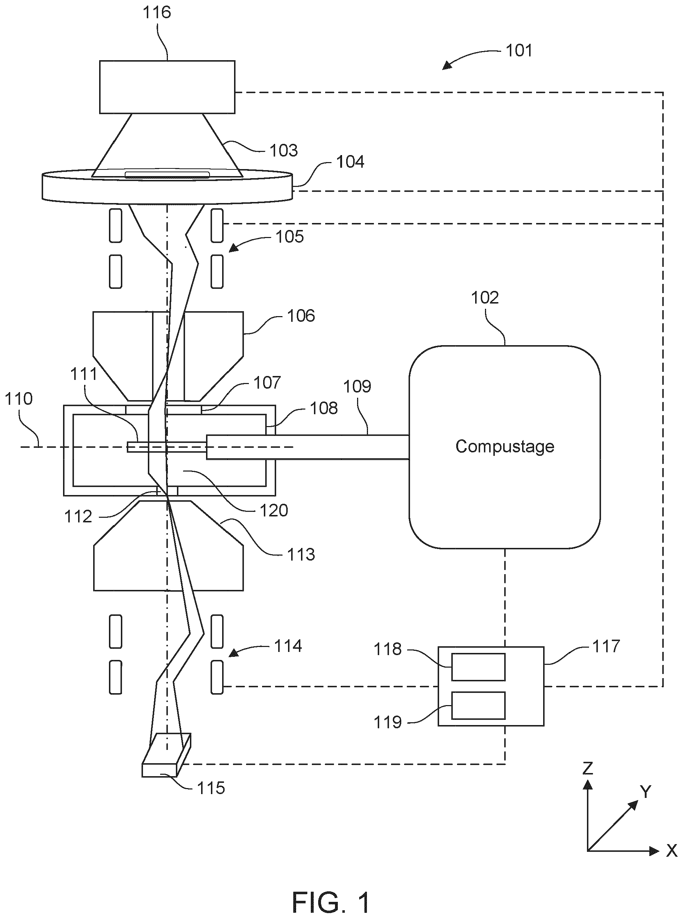

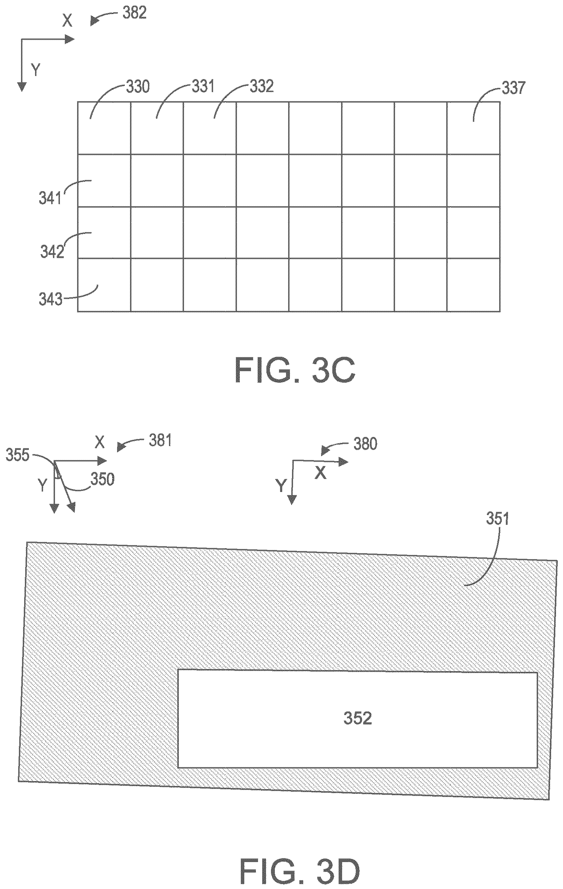

Turning to FIG. 1, a highly simplified TEM system 101 is shown. Electron beam 103 generated by the electron source 116 is limited by aperture 104 before deflected by beam deflection coils 105. The beam deflection coils may shift or move the region irradiated by the electron beam (i.e., the irradiation zone) in the sample plane 110 (i.e., X-Y plane). The deflected beam enters an upper opening 107 of the optional cryo-box 108 though the upper objective pole piece 106. A sample (not shown) positioned on one end of the sample holder 109 is irradiated by the electron beam entering though the upper opening 107. The beam profile at the sample plane, which forms the irradiation zone, is determined in part by the beam limiting aperture 104. Position of the sample can be adjusted by operating one or more actuators of stage 102. For example, the sample may be shifted in the sample plane via the sample holder by operating the stage 102. Radiations 120 from the sample exit the cryo-box 108 via lower opening 112 of the cryo-box. The radiations 120 pass through the lower objective pole piece 113 and are deflected by the image deflection coils 114 in descanning mode, and then reach detector 115. The detector 115 may be a pixelated detector having multiple detecting elements for receiving the radiations. FIG. 3C shows one example arrangement of the multiple detecting elements. In one example, the detector 115 is a pixelated detector with particle counting and tracking capability. For example, the detector is a Timepix-based detector. In another example, the detector is an active pixel CMOS direct electron detection camera.

The signals from the detector 115 pass along control lines (buses) to controller 117 for processing and forming a sample image. The sample image may be displayed on a display unit (not shown). Such processing may include operations such as combining, integrating, subtracting, false coloring, edge enhancing, and other processing known to the skilled artisan. The controller includes a non-transitory memory 119 for storing computer readable instructions and a processor 118. Methods disclosed herein may be implemented by executing the computer readable instructions stored in the non-transitory 119 in the processor 118. For example, the controller may control the microscope to direct the electron beam to the sample, collect data, and process the collected data. The controller may adjust the electron beam energy, position, illumination area, and intensity by adjusting one or more lenses and/or the electron source. The controller may adjust the sample position via the sample holder and stage. The controller may adjust location of the irradiation zone via the image deflection coils. The controller may adjust sample regions to be imaged (e.g., the location of the detection zone) via the image deflection coils.

The TEM system is shown here as an example of the charged particle microscope. The method and system configuration disclosed herein can be applied to other types of charged particle microscopes.

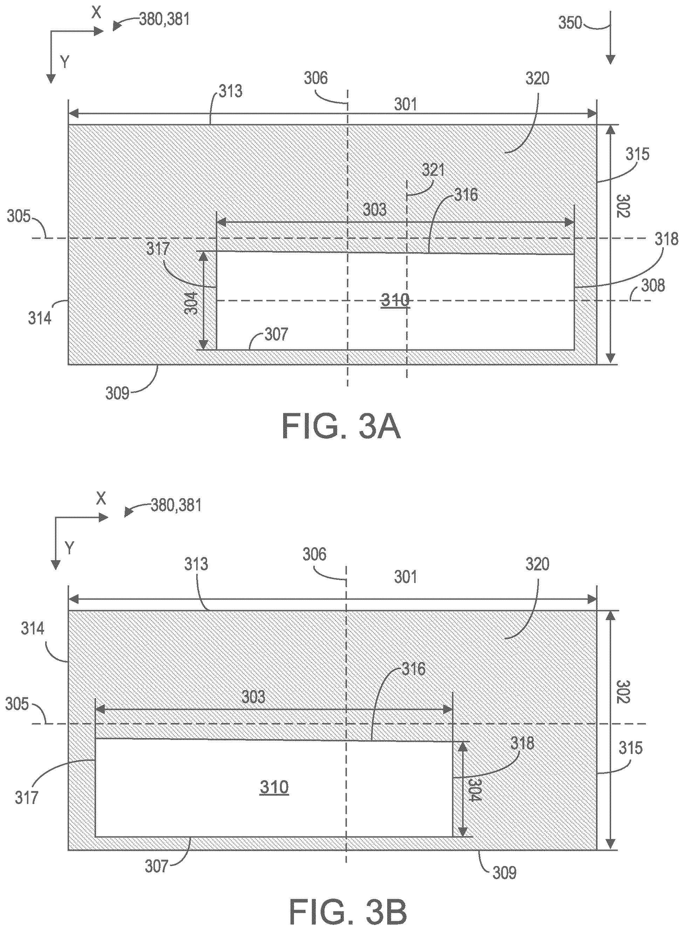

FIGS. 3A and 3B illustrate two example arrangements of the irradiation zone and the detection zone. FIG. 3C illustrates one example arrangements of the detecting elements of a detector that can be used for detecting radiations from the detection zones shown in FIGS. 3A and 3B. In these examples, the irradiation zone and the detection zone are both rectangular.

In FIGS. 3A and 3B, the irradiation zone 320 is the region that is irradiated by the charged particle beam in the sample plane. Coordinate system 380 shows the coordinates of the irradiation zone, and coordinate system 381 shows the coordinates of the detection zone. Herein, the irradiation coordinates and the detection coordinates are the same. The Y axis is the first irradiation axis and the X axis is the second irradiation axis. The irradiation zone is scanned in direction 350 along the first irradiation axis (Y axis of 380,381) within the sample plane. The detection zone 310 is within and smaller than the irradiation zone 320. The first detection axis is the same as the first irradiation axis, and the second detection axis is the same as the second irradiation axis. The width 304 (along the scan direction 350) of the detection zone is less than the width 302 of the irradiation zone. The length 301 of the irradiation zone may be larger than or the same as the length 303 of the detection zone. The irradiation zone is bounded by first irradiation edge 309, second irradiation edge 313, third irradiation edge 315, and fourth irradiation edge 314. The irradiation zone has a width 302 and a length 301. The detection zone is bounded by first detection edge 307, second detection edge 316, third detection edge 318, and fourth detection edge 317. The detection zone has a width 304 and length 303.

In both FIGS. 3A and 3B, the detection zone 310 offsets from the irradiation zone 320 towards the scan direction 350. Central axis 308 of the detection zone 310 does not overlap with the central axis 305 of the irradiation zone 320. The distance between the first irradiation edge 309 and the first detection edge 307 is smaller than the distance between second irradiation edge 316 and the second detection edge 313. In this way, the irradiation zone 320 may extend in a direction opposite to the scan direction 350 (against the direction of Y-axis) to cover a portion of the materials surrounding the sample region and facilitate charge removal. Further, the distance between the first irradiation edge 309 and the first detection edge 307may be greater than zero, so that the initial radiations generated responsive to the irradiations are not detected by the detector.

Herein, the central axis 321 of the detection zone 310 does not overlap with the central axis 306 of the irradiation zone 320. The detection zone 310 may offsets towards different directions along the X axis, as shown in FIG. 3A and FIG. 3B. In other words, the distance between the third irradiation edge 315 and the third detection edge 318 may be either smaller (FIG. 3A) or larger (FIG. 3B) than the distance between the fourth irradiation edge 314 and the fourth detection edge 317. The direction that the detection zone offsets from the irradiation zone may be determined on which part of the sample region is scanned, so that the irradiation zone may extend to cover the materials surrounding the sample region, as well as the already scanned sample region. In some examples, the third irradiation edge 315may overlap with the third detection edge 318, and/or the fourth irradiation edge 314 may overlap with the fourth detection edge 317.

FIG. 3C illustrates an example arrangement of multiple detecting elements (or pixels) of a pixelated detector for receiving/acquiring radiations from the detection zone in FIGS. 3A and 3B. Coordinate system 382 is the detector's coordinate system. The detecting elements are arranged in a 2D array extending along the first detector axis (Y axis of 382) and the second detector axis (X axis of 382). The first detector axis corresponds to the first detection axis (Y axis of 381) and the second detector axis corresponds to the second detection axis (X axis of 381). Detecting elements (e.g., 330-337) arranged along the second detector axis can detect spatially resolved radiations along the second detection axis. Detecting elements (e.g., 330, 341, 342, and 343) arranged along the first detector axis may detect spatially resolved radiations along the first detection axis. The number of the detecting elements along the first detector axis is less than the number of the detecting elements along the second detector axis. The shape of each detecting elements may be square or rectangular. In some examples, the detecting element may be of other shapes. The spatial resolution of each detecting elements may be higher along the second detection axis comparing to the first detection axis. In one example, the first detector axis is aligned with the scan direction 350. In some examples, the detecting elements shown in FIG. 3C may be a subset of detecting elements of the detector.

In some embodiments, the detecting element is arranged in a 1D array. In other words, the number of the detecting elements along the first detection axis is one. In some embodiments, the irradiation zone may be of other shapes, such as round, square, or oval.

In some embodiments, the scan direction may not align with the detection axis or the irradiation axis. For example, the irradiation zone 320 may be scanned along a direction has a non-zero angle from direction 350. In some embodiments, the detection axis may have an angle less than 45 degrees from the scan direction.

FIG. 3D illustrates another example arrangement of the irradiation zone 351 and detection zone 352. The detection zone is rectangular, and defined by the first detection axis (Y-axis of the detection coordinate system 381), and the second detection axis (X-axis of the detection coordinate system 381). The detection coordinate system 381 is not aligned with the irradiation coordinate system 380. The scan direction 350 is not aligned with either the first detection axis (Y axis of the detection coordinate system 381) nor the first irradiation axis (Y axis of the irradiation coordinate system 381). The first detection axis (Y axis of the detection coordinate 381) has an angle 355 from the scan direction 350. The angle 355 is less than 45 degrees.

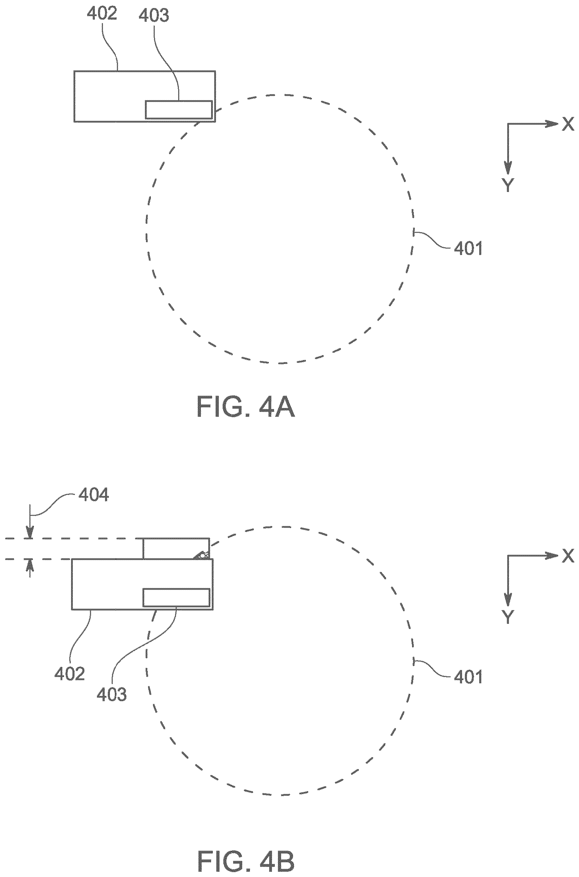

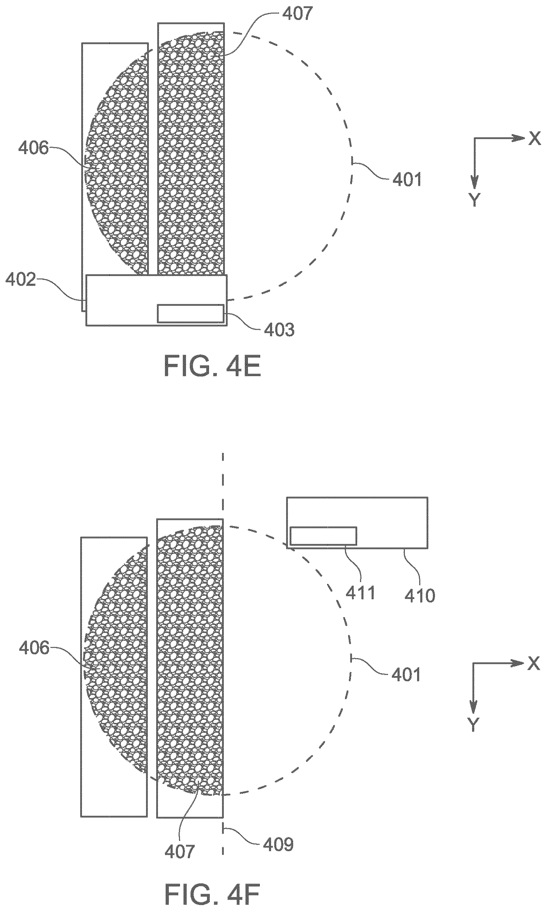

FIGS. 4A-4H illustrate one example scanning scheme for collecting data from a round sample region. The sample region 401 herein is a 2 um diameter hole of a TEM grid. The sample (e.g., including multiple particles) may be vitrified within the hole and imaged using the TEM system of FIG. 1. Sequentially shown from FIG. 4A to FIG. 4E, the left side (e.g., left relative to the central axis 409) of the sample region 401 is scanned with irradiation zone 402 and data are collected from the corresponding detection zone 403. After that, sequentially shown from FIG. 4F to FIG. 4H, the right side (e.g., right relative to the central axis 409) of the sample region is scanned with irradiation zone 410 and data are collected from the corresponding detection zone 411. The relative arrangement of the irradiation zone and the detection zone can be the same as shown in FIGS. 3A-3B.

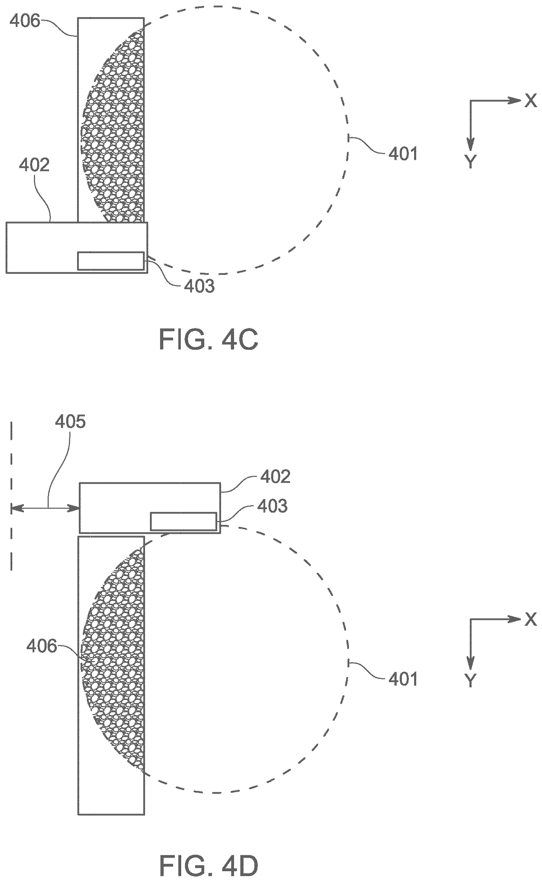

In FIG. 4A, at the very first beam location, the irradiation zone 402 is positioned at the upper left corner of the sample region 401. At the next beam position shown in FIG. 4B, the irradiation zone moves in a scan direction along the first irradiation axis (Y axis) by shifting the beam. As the irradiation zone further scans along the first irradiation axis, sample data are collected from a first column 406 of the sample region. Sample image generated based on data collected from the first column 406 is shown in FIG. 4C. At each of the beam locations for scanning the first column, the irradiation zone overlaps with region outside of the sample region 401, for avoiding charge built-up.

At FIG. 4D, the irradiation zone 402 is shifted along the second irradiation axis (X-axis), towards the right side of the first column. Additionally, the irradiation zone 402 is shifted back along the first irradiation axis to start collecting data from a second column 407 of the sample region. The shift of the irradiation zone from FIG. 4C to FIG. 4D may be done by beam shift via beam deflecting coils and/or sample shift via sample holder. Additionally or alternatively, the shift can be achieved by adjusting the beam limiting aperture. The irradiation zone 402 scans along the scan direction (Y axis direction) and finishes scanning the second column 407 at FIG. 4E. In some examples, the second column 407 may be acquired by scanning the irradiation zone in a direction against the Y axis direction. In this case, the detection zone is offset towards the scan direction (against of the Y axis direction) relative to the irradiation zone.

The relative position of the detection zone 403 relative to the irradiation zone 402 is shown in FIG. 3A, wherein the detection zone offsets towards the un-scanned sample region (right side). As such, radiation damage to the un-scanned sample region can be minimized, because the non-overlapped area between the irradiation zone and the detection zone are mostly in the already scanned sample region.

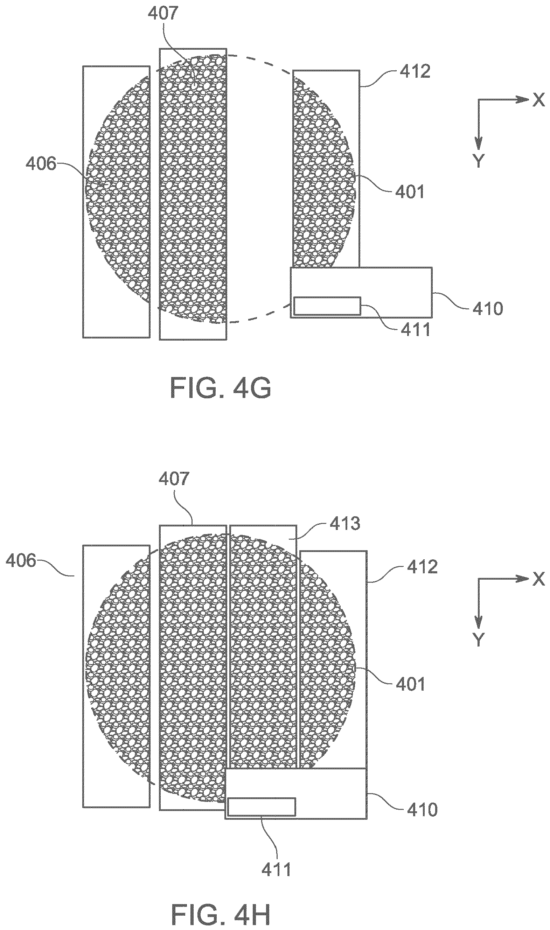

In FIG. 4F, comparing to the location of irradiation zone 402, the irradiation zone 410 is shifted along the second irradiation axis (X axis), towards the right side of the first column. Additionally, the irradiation zone 410 is shifted back along the first irradiation axis to start collecting data from a third column 412 of the sample region. At the same time, the relative position of the detection zone 411 from the irradiation zone 410 is different from the ones shown in FIGS. 4A-4E. In FIG. 4E, the detection zone offsets towards the left side of the irradiation zone, as shown in FIG. 3B. As such, the irradiation zone 410 can overlap with areas surrounding the sample region 401, and can also reduce radiation damage to the unscanned sample region. The irradiation zone 410 is scanned in the scan direction along the first irradiation axis and completed data collection of the third column 412, as shown in FIG. 4G. The irradiation zone is then shifted along the second irradiation axis and scanned along the first irradiation axis to complete data collection of the fourth column 413, as shown in FIG. 4H.

Though FIGS. 4A-FIGS. 4H show beam locations as discrete locations, the scan along the first irradiation direction may be performed continuously. That is, the irradiation zone is continuously moving or scanning along the first irradiation axis at a non-zero scan speed.

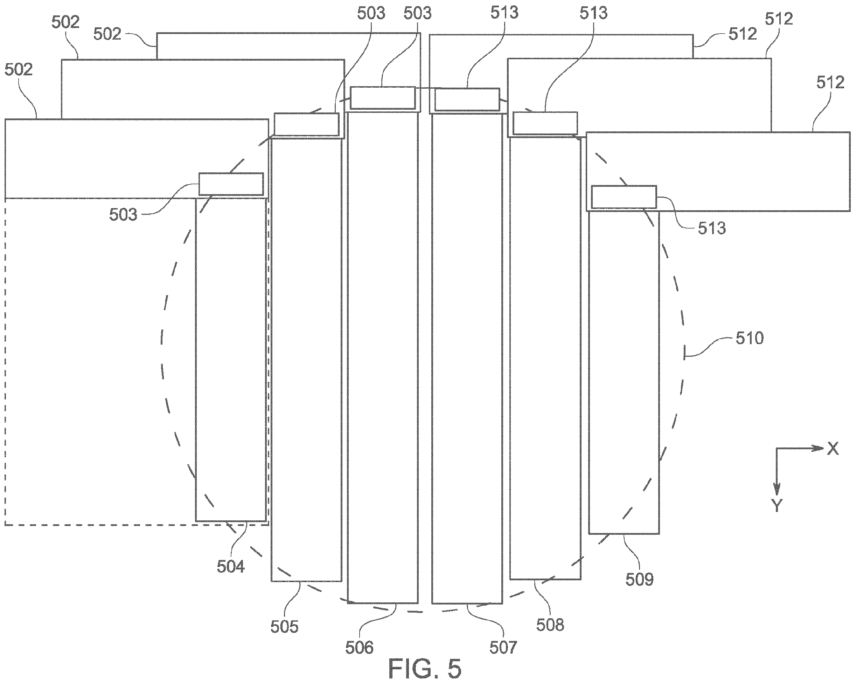

FIG. 5 is an integrated view of irradiation zone and detection zone locations during the scan of a sample region 510. Similar to FIGS. 4A-4H, two relative positions between the irradiation zone and the detection zone are used for scan different sides of the sample region. Different from FIGS. 4A-4H, the sample region is covered by six columns (i.e., scanned six times along the first irradiation direction).

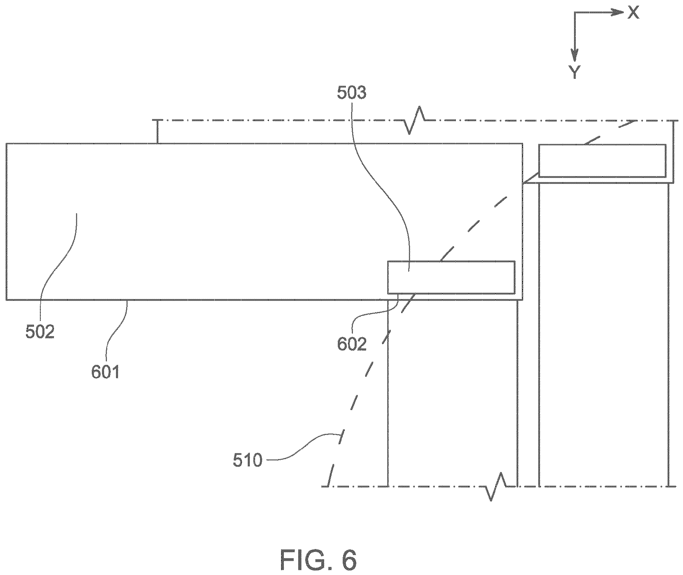

FIG. 6 is a closed-up view of the upper left region of FIG. 5. The first detection edge 602 does not overlap with the first irradiation edge 601. As such, the very first few electrons generated in sample region between the first detection edge 602 and the first irradiation edge 601 are not detected. The distance between the two edges may be arranged based on the speed of the scan along the first axis and an estimated flux of the received radiation.

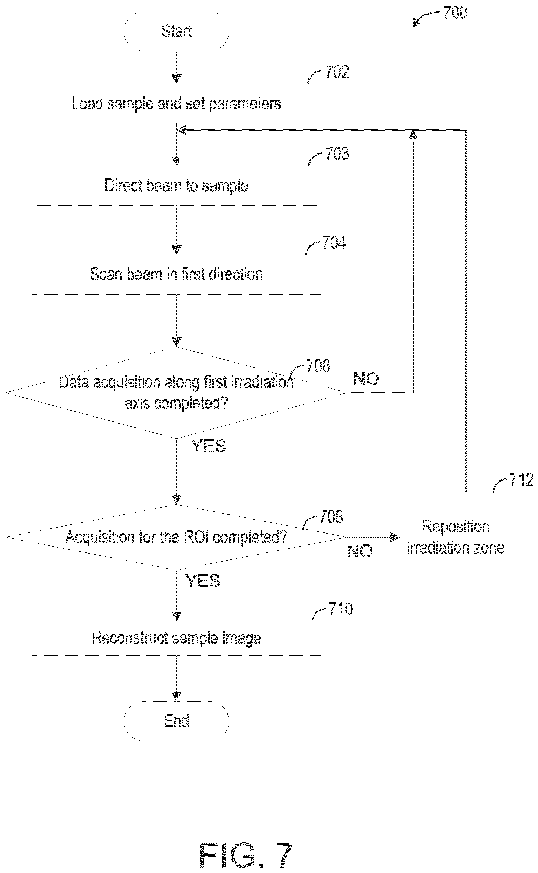

FIG. 7 shows method 700 for imaging a sample using a charged particle microscope, such as the TEM system shown in FIG. 1.

At 702, a sample is loaded into the charged particle microscope and parameters for imaging the sample are set. In one example, the sample is a vitrified sample positioned on a TEM grid. The sample may be loaded into the microscope using a sample holder. Loading the sample may include positioning the sample in the sample plane and in the beam path. In some examples, one or more sample images may be acquired for assisting positioning the sample. The parameters for imaging the sample may include one or more of the beam current, scan path, scan speed, the size of the irradiation zone and the detection zone, the positions of the detection zone relative to the irradiation zone. The parameters may be determined based on the sample type. For example, based on the user input of sample type, the scan speed can be determined based on the dose limit of the sample type. A flux of the received radiations from the sample may be estimated based on the sample type and sample distribution.

In one example, the size and shape of the irradiation zone may be selected based on one or more of the region of interest (ROI) to be imaged on the sample, the dose limit, and the scan speed. The ROI may be of any shape, such as circle or rectangular. Further, position of the detection zone relative to the illumination zone may be determined. In some examples, the sizes of one or both of the irradiation zone and the detection zone may change during the scan. In some examples, the relative position of the detection zone relative to the irradiation zone remains the same throughout the scan. The position of the detection zone relative to the irradiation zone can be determined based on one or more of the estimated flux, the scan speed, sample type, and the scan path. For example, the distance between the first detection edge and the first irradiation edge may increase with the speed of the scan and decrease with the increased estimated flux. As another example, the offset of the detection zone with respect to the irradiation zone may depend on the scan path as shown in FIGS. 4A-4H. In yet another example, the scan direction may vary during the scan. For example, the scan can have a serpentine scan path. In some embodiments, one or more test scans may be performed, for example on a test sample, to tune one or more of the imaging parameters before imaging the sample of interest.

At 703, the charged particle beam is directed towards the sample via the beam deflection coils and forms an irradiation zone in the sample plane. Step 703 may include selecting a position of the detection zone relative to the irradiation zone from 702, and determining the corresponding parameters for the beam deflection coils and the image deflection coils.

At 704, the irradiation zone is scanned in the first direction along the first irradiation axis in the sample plane, according to the parameters set at 702, and radiations from the detection zone is collected by the detector. The scan may be a stepwise scan or continuous scan. In some embodiments, the sample image may be displayed and updated while collecting the data. In some examples, drift may be estimated during the scan. The drift may include system drift and sample drift. To correct the drift, the scan path, or the location of the irradiation zone, may be adjusted based on the estimated drift.

At 706, method 700 checks whether the data acquisition along the first irradiation axis is completed (i.e., data collection along one column is completed). If the answer is YES, method 700 moves to 708. Otherwise, the scan continues in the first direction.

At 708, method 700 checks whether the data collection from the ROI is complete. If the answer is YES, one or more sample images are reconstructed based on the collected data at 710. If the data collection from the ROI is not complete, the irradiation zone is repositioned on the sample plane at 712 to continue the data collection of another area in the ROI. For example, at 712, the irradiation zone may be shifted along a second irradiation axis to collect data from another column of the ROI. The position of the detection zone relative to the irradiation zone may also change at step 703 for collecting radiations corresponded to the repositioned irradiation zone.

The technical effect of scanning the irradiation zone and acquiring radiations from the detection zone, as well as detecting the radiations via a detector with a first number of the multiple detecting pixels arranged along the first detector axis is lower than a second number of the multiple detecting pixels arranged along the second detector axis is that the cost of the detector can be lowered while obtaining sample images with high spatial resolution. By using special detection zone shape (formed by the aperture), the method enables high efficiency sample region sampling and reduced sample damage. Further, by scanning the irradiation zone, the drift correction may be applied via real-time feedback. The method can scan larger FOVs compared to standard methods. The technical effect of having the detection zone within and smaller than the irradiation zone is that the irradiation zone may cover materials surrounding the sample region for charged removal. The technical effect of constructing the sample image based on the time information of the received radiation and the scan speed is that the spatial resolution requirement of the detector along first detector axis is lower. Further, the beam can continuously scan along the scan direction, therefore reducing the overall data acquisition duration. Additionally, this method is less sensitive to the number of defected pixels in the detector array and the illumination imperfections.

## Claims

1. A method for imaging a sample, comprising:
directing a charged particle beam toward the sample and forming an irradiation zone in a sample plane;
scanning the irradiation zone substantially in a first direction in the sample plane, and detecting radiations from a detection zone with multiple detecting pixels of a detector, wherein a first detector axis of the detector corresponds to a first detection axis of the detection zone, and a second detector axis of the detector corresponds to a second detection axis of the detection zone, wherein a first number of the multiple detecting pixels arranged along the first detector axis is lower than a second number of the multiple detecting pixels arranged along the second detector axis, and wherein the first detection axis is orientated at an angle of less than 45 degrees from the first direction; and
reconstructing a sample image based on the radiations detected during the scan.

2. The method of claim 1, wherein scanning the irradiation zone substantially in the first direction includes shifting the charged particle beam substantially in the first direction relative to the sample.

3. The method of claim 1, wherein sizes, shapes, and relative positions of the irradiation zone and the detection zone remain the same while scanning the irradiation zone substantially in the first direction.

4. The method of claim 1, wherein the detection zone is within the irradiation zone and offsets towards the first direction relative to the irradiation zone.

5. The method of claim 4, wherein the detection zone is bounded a first detection edge and a second detection edge parallel to the second detection axis, the irradiation zone is bounded by a first irradiation edge and a second irradiation edge normal to the first direction, the first detection edge and the first irradiation edge are arranged toward the first direction relative to the second detection edge and the second irradiation edge, and wherein a first distance between the first detection edge and the first irradiation edge is smaller than a second distance between the second detection edge and the second irradiation edge.

6. The method of claim 5, wherein the first distance between the first detection edge and the first irradiation is determined based on a speed of the scan of the irradiation zone in the first direction and an estimated flux of the detected radiation.

7. The method of claim 4, wherein the detection zone is bounded by a third detection edge and a fourth detection edge parallel to the first detection axis, the irradiation zone is bounded by a third irradiation edge and a fourth irradiation edge oriented along the first direction, and wherein one of the third and the fourth detection edges substantially overlaps with one of the third and fourth irradiation edges.

8. The method of any one of claims 1-7, further comprising: after scanning the sample for a first distance substantially along the first direction, shifting the irradiation zone in a second, different, direction for a second distance; and scanning the shifted irradiation zone substantially in the first direction and detecting radiations from the detection zone.

9. The method of any one of claims 1-8, wherein scanning an irradiation zone in the first direction in the sample plane includes continuously moving the irradiation zone in the first direction, and wherein reconstructing a sample image based on the radiation detected during the scan includes reconstructing a location of the detected radiation along the first detection axis based on time information of the detected radiation and a speed of the irradiation zone scanning in the first direction.

10. A charged particle microscope, comprising:
a sample holder for positioning a sample in a sample plane;
a charged particle column for directing a charged particle beam toward the sample plane and forming an irradiation zone in the sample plane;
a pixelated detector for detecting radiations generated from a detection zone of the sample responsive to irradiating the sample with the charged particle beam, wherein a first detector axis of the detector corresponds to a first detection axis of the detection zone, and a second detector axis of the detector corresponds to a second detection axis of the detection zone; and
a controller including a non-transitory memory for storing computer readable instructions and a processor, by executing the computer readable instructions in the processor, the charged particle microscope is configured to:
scan, via the charged particle column, the irradiation zone substantially in a first direction in the sample plane;
detect, via multiple pixels of the detector, radiations from the detection zone, wherein a first number of the multiple detecting pixels arranged along the first detector axis is lower than a second number of the multiple detecting pixels arranged along the second detector axis, and wherein an angle of the first direction from the first detection axis is less than 45 degrees; and
reconstruct a sample image based on the radiations detected during the scan.

11. The charged particle microscope of claim 10, wherein the charged particle column directing a charged particle beam toward the sample plane via one or more beam deflection coils and a beam limiting aperture within the charged particle column, and wherein the charged particle column scans the irradiation zone by adjusting the beam deflections coils and/or the beam limiting aperture.

12. The charged particle microscope of any one of claims 10-11, further include one or more image deflection coils for directing radiations from the detection zone towards the detector, wherein a relative position of the detection zone within the irradiation zone is adjusted by the one or more image deflection coils.

13. The charged particle microscope of any one of claims 10-12, wherein first direction is aligned with the first detection axis.

14. The charged particle microscope of any one of claims 10-13, wherein the charged particle microscope includes a transmission electron microscopy system.

15. The charged particle microscope of any one of claims 10-14, wherein the detector includes a first number of pixels, and wherein detect radiations from the detection zone includes detect the radiations from the detection zone using a second, lower, number of the pixels of the detector.
